# FASCICULE DE BREVET EUROPEEN

(11) **EP 1 440 467 B1**
(45) Date de publication et mention de la délivrance du brevet: **22.06.2011**
(21) Numéro de dépôt: 02783214.6
(22) Date de dépôt: 26.09.2002
(51) Int. Cl.: H01L 21/66, H01L 21/265, G01R 31/28

(54) **PROCEDE DE CARACTERISATION D'UNE ETAPE D'IMPLANTATION DANS UN SUBSTRAT**
VERFAHREN ZUR CHARAKTERISIERUNG EINES IMPLANTATIONSSCHRITTES IN EINEM SUBSTRAT
METHOD OF CHARACTERISING AN IMPLANTATION STEP IN A SUBSTRATE

(30) Priorité: 28.09.2001 FR 0112507
(43) Date de publication de la demande: 28.07.2004
(73) Titulaire: S.O.I.Tec Silicon on Insulator Technologies, 38190 Bernin (FR)
(72) Inventeur: MALEVILLE, Christophe, F-38660 La Terrasse (FR); SCHWARZENBACH, Walter, F-38330 Saint-Nazaire-les-Eymes (FR)
(74) Mandataire: Callon de Lamarck, Jean-Robert
(86) Numéro de dépôt international: PCT/FR2002/003281
(87) Numéro de publication internationale: WO 2003/030249

(56) Documents cités:
- WO-A-99/08307
- US-A- 5 760 409
- SCHIETTEKATTE F ET AL: "Dose and implantation temperature influence on extended defects nucleation in c-Si" NUCLEAR INSTRUMENTS & METHODS IN PHYSICS RESEARCH, SECTION - B: BEAM INTERACTIONS WITH MATERIALS AND ATOMS, NORTH-HOLLAND PUBLISHING COMPANY, vol. 164-165, avril 2000 (2000-04), pages 425-430, XP004195210 . AMSTERDAM, NL ISSN: 0168-583X
- HUANG L-J ET AL: "MODEL FOR BLISTERING AND SPLITTING OF HYDROGEN IMPLANTED SILICON AND ITS APPLICATION TO SILICON-ON-QUARTZ" ELECTROCHEMICAL SOCIETY PROCEEDINGS, PROCEEDINGS OF 8TH INTERNATIONAL SYMPOSIUM ON SEMICONDUCTOR SILICON, vol. 98-1, 4 - 8 mai 1998, pages 1373-1384, XP000905645 San Diego, CA., USA ISSN: 0191-2917
- DA SILVA D L ET AL: "The effects of implantation temperature on He bubble formation in silicon" NUCLEAR INSTRUMENTS & METHODS IN PHYSICS RESEARCH, SECTION - B: BEAM INTERACTIONS WITH MATERIALS AND ATOMS, NORTH-HOLLAND PUBLISHING COMPANY. AMSTERDAM, NL, vol. 175-177, avril 2001 (2001-04), pages 335-339, XP004242656 ISSN: 0168-583X
- BRUEL M: "APPLICATION OF HYDROGEN ION BEAMS TO SILICON ON INSULATOR MATERIAL TECHNOLOGY" NUCLEAR INSTRUMENTS & METHODS IN PHYSICS RESEARCH, SECTION - B: BEAM INTERACTIONS WITH MATERIALS AND ATOMS, NORTH-HOLLAND PUBLISHING COMPANY. AMSTERDAM, NL, vol. 108, no. 3, 1 février 1996 (1996-02-01), pages 313-319, XP000611125 ISSN: 0168-583X
- PATENT ABSTRACTS OF JAPAN vol. 010, no. 201 (E-419), 15 juillet 1986 (1986-07-15) & JP 61 043417 A (HITACHI LTD), 3 mars 1986 (1986-03-03)
- LANZIERI C ET AL: "ACTIVATION UNIFORMITY IMPROVEMENT OF UNDOPED SEMI-INSULATING GAAS WITH AN IMPROVED POST-IMPLANT ANNEAL FURNACE" JOURNAL OF APPLIED PHYSICS, AMERICAN INSTITUTE OF PHYSICS. NEW YORK, US, vol. 66, no. 8, 15 octobre 1989 (1989-10-15), pages 3643-3646, XP000073904 ISSN: 0021-8979

## Description

La présente invention concerne les opérations de caractérisation d'un traitement que l'on a fait subir à un substrat de matériau.

Plus précisément, l'invention concerne un procédé de caractérisation de dose d'une étape d'implantation d'au moins une espèce dans un substrat.

On précise que le substrat peut en particulier être un substrat en un matériau semiconducteur tel que du silicium.

On précise également que par « espèce », on entend tout type d'ion ou d'atome avec lequel on a implanté un substrat. Comme on le verra, dans une application préférée de l'invention, les espèces peuvent être des ions H⁺ et/ou des atomes H d'hydrogène par exemple.

On peut en effet réaliser une implantation d'espèces (ions ou atomes) dans un substrat de matériau, par exemple en exposant la surface du substrat à un bombardement de ces espèces.

En fonction de l'énergie associée au bombardement, et de la nature des espèces implantées, lesdites espèces s'implantent dans la masse du substrat avec une répartition présentant un maximum marqué à une profondeur donnée. On crée ainsi un maximum de concentration des espèces implantées à une profondeur donnée du substrat.

Et il est possible de faire varier cette profondeur d'implantation en contrôlant l'énergie d'implantation, pour une espèce donnée.

Le procédé SMARTCUT^{®} dont on trouvera une description générale dans le document FR-2 681 472 est un exemple de procédé mettant en oeuvre une telle étape d'implantation.

Dans un procédé de type SMARTCUT^{®} en effet, l'étape d'implantation est destinée à définir dans le substrat (qui est réalisé dans un matériau semi-conducteur tel que du silicium monocristallin), un plan de fragilisation.

Une étape ultérieure de ce procédé est une étape de clivage destinée à assurer au moins partiellement une fracture selon le plan de fragilisation défini au niveau de la couche d'espèces implantées.

Ainsi, dans l'exemple d'un procédé de type SMARTCUT^{®}, l'étape d'implantation définit le plan de fragilisation : en fonction des caractéristiques de l'implantation (et en particulier de la dose d'implantation), le clivage sera réalisé plus au moins facilement.

En outre, l'étape d'implantation détermine dans une certaine mesure la rugosité de surface des tranches après le clivage.

On a donc vu à propos de l'exemple du procédé SMARTCUT^{®} qu'il serait souhaitable de pouvoir caractériser une dose d'implantation d'espèces dans un substrat de matériau.

Et ce besoin s'applique également à l'implantation d'espèces dans d'autres contextes.

De manière générale, il serait ainsi souhaitable de pouvoir caractériser deux paramètres importants de l'implantation, à savoir :
- la dose d'espèces implantées dans le substrat, et
- l'uniformité de l'implantation dans le substrat, en parcourant la surface dudit substrat.

On connaît des méthodes et des dispositifs qui apportent des réponses au moins partielles à ce besoin.

Il est ainsi connu selon un premier type de méthode de mesurer in situ, c'est à dire en temps réel lors de l'implantation, la dose d'espèces implantées.

Le document US-4 743 767 divulgue ainsi des moyens permettant de mesurer un courant électrique représentatif de l'implantation.

La méthode mise en oeuvre dans ce brevet est fondée sur une mesure électrique dans un faisceau de particules chargées avec lesquelles on désire implanter des substrats.

Un premier inconvénient de cette méthode et qu'elle ne permet pas de mesurer les espèces électriquement neutres qui sont implantées dans les substrats. Or, même dans le cas de l'implantation par des espèces initialement chargées (ion H⁺ par exemple), certaines de ces espèces peuvent entrer en collision avec des éléments résiduels présents dans la chambre d'implantation (atomes et/ou molécules d'oxygène ou d'azote par exemple) et perdre ainsi leurs charges électriques.

De telles espèces rendues électriquement neutres peuvent conserver assez d'énergie pour s'implanter effectivement dans le substrat, et la méthode mentionnée ci-dessus ne permet pas de les prendre en compte.

De la même manière, cette méthode ne permet pas de prendre en compte de manière représentative des espèces dont la charge électrique s'est, de manière générale, transformée.

Ceci par exemple être le cas d'ions H₂⁺ qui, ayant un rapport (masse / charge électrique) double de celui d'un ion H⁺, sont chacun comptabilisés comme un seul ion par une telle méthode, alors qu'une dose double est effectivement implantée.

En outre, cette méthode ne permet pas de caractériser l'uniformité d'implantation.

Il existe également des méthodes de mesure in situ qui proposent des mesures palliatives à certain des inconvénients mentionnés ci-dessus.

On trouvera par exemple dans le document US-4 751 393 une description d'une méthode permettant d'interpoler des mesures ponctuelles afin de fournir une information au moins partielle sur l'uniformité d'implantation.

Par ailleurs, le document US-5 998 798 propose quant à lui de pallier dans une certaine mesure à l'absence de mesure des particules neutres, par compensation.

Mais de telles tentatives ne prennent en compte qu'un des inconvénients mentionnés ci-dessus à propos des méthodes in situ.

De plus, les réponses apportées sont imparfaites (simple interpolation en ce qui concerne l'uniformité, et compensation a posteriori pour la mesure des particules neutres - au lieu d'une mesure directe de l'implantation de ces particules neutres).

Un deuxième type de méthode connu consiste à mesurer les caractéristiques de l'implantation ex situ, c'est à dire après la réalisation de l'étape d'implantation.

Une première méthode de ce type constitue à effectuer après l'implantation un recuit dont les paramètres sont contrôlés afin de « fixer » les espèces implantées dans la structure du substrat.

Suite à ce recuit, on caractérise électriquement le substrat implanté de manière à avoir une mesure de la dose d'espèces implantées.

Une limitation importante de ce type de méthode est qu'elle n'est pas adaptée à la mesure de dose d'implantations des espèces légères telles que l'hydrogène (ou encore l'hélium).

Cette limitation est particulièrement pénalisante dans le cas de la caractérisation d'une implantation par un ion léger tel que l'hydrogène ce qui correspond à une application préférée d'un procédé de type SMARTCUT^{®}.

Dans une deuxième méthode de mesure ex situ, on effectue une caractérisation optique de la couche superficielle du substrat implanté.

Les documents US-5 834 364 et US-4 807 994 donnent des exemples d'une telle méthode.

Mais ici encore, la méthode est adaptée à la mesure de l'implantation d'ions lourds tels que du phosphore ou du bore, et se trouve mal adaptée pour la mesure de l'implantation d'ions légers tel que l'hydrogène.

En outre, la mise en oeuvre de cette méthode nécessite des équipements spécifiques (du type Thermaprobe^{®}).

Le document US-4 807 994 est en outre limité à la mesure de l'uniformité d'implantation. Par ailleurs, ce document divulgue une méthode limitée à la caractérisation de doses d'implantation relativement faibles, alors que les doses d'implantation misent en oeuvre dans un procédé du type SMARTCUT^{®} sont typiquement supérieures à 10¹⁶ atomes par cm².

Selon une troisième méthode de mesure ex situ, il est connu d'analyser la partie réfléchie d'un faisceau mono-énergétique de particules de haute énergie dirigé sur un substrat préalablement implanté, pour établir un profil d'implantation dans une couche superficielle du substrat.

On trouvera une description d'une telle méthode dans l'article « Rutherford backscattering spectrometry (RBS) » de Scott M. BAUMANN édité par la société Charles EVENS & Associates - 810 kifer Road Sunnyvale, CALIFORNIA USA.

Une première limitation d'une telle méthode est qu'elle est mal adaptée à la caractérisation de l'uniformité d'implantation.

En effet, il faudrait pour cela procéder à une multitude de mesures point par point, ce qui s'avérerait fastidieux et coûteux.

En outre, l'épaisseur de la couche du substrat que l'on peut caractériser de la sorte demeure limitée.

Enfin, la précision des mesures obtenues par ce type de méthode est limitée à 5 %, ce qui est insuffisant pour certaines applications.

Enfin, une quatrième méthode de mesure ex situ consiste à mettre en oeuvre un faisceau énergétique pour graver la surface d'un substrat implanté puis à analyser le substrat gravé dans sa masse.

Une telle méthode est désignée par l'appellation anglo-saxonne de « secondary ion mass spectrometry ».

Un premier inconvénient de ce type de méthode est qu'ici encore, elle est mal adaptée à la caractérisation de l'uniformité de l'implantation.

En outre, cette méthode se révèle très onéreuse à mettre en oeuvre.

Il apparaît ainsi que s'il existe différentes méthodes permettant dans une certaine mesure de caractériser une dose d'espèces implantées, ou une uniformité d'implantation, il demeure un besoin pour une méthode rapide et simple permettant de caractériser simultanément ces deux aspects, en s'affranchissant des inconvénients mentionnés ci-dessus.

On précise par ailleurs qu'il a déjà été possible de mettre en évidence l'influence de différents paramètres d'une étape d'implantation sur la structure d'un substrat implanté.

On connaît ainsi un article de Huang L.J. et al. "Model for blistering of hydrogen implanted silicon and its application to silicon-on-quartz" Electrochemical society proceedings, proceedings of 8th international symposium on semiconductor silicon (vol. 98-1, 4-8 mai 1998, pages 1373-1384).

Mais cet article se contente d'observer un effet résultant sur le substrat après implantation, en fonction des variations des différents paramètres d'implantation.

En aucun cas cet article ne suggère d'exploiter à l'inverse l'observation de cet effet résultant pour caractériser la dose implantée.

On remarquera en outre qu'en ce qui concerne la caractérisation de la dose d'implantation, cet article divulgue une méthode d'observation du substrat implanté qui est relativement lourde à mettre en oeuvre (observation de type TEM, qui vise à fournir une image en coupe dans la profondeur du substrat).

On connaît également d'autres documents qui caractérisent dans une certaine mesure l'influence d'une dose d'implantation sur les caractéristiques du substrat implanté.

On peut citer par exemple un article de Schiettekatte et al. « Dose and implantation temperature influence extended defects nucleation in c-Si, Nuclear Instrument and methods in physics research, section B : Beam interactions with materials and atoms, North-Holland publishing company, vol. 164-165, avril 2000 (2000-04), pages 425-430.

Mais ici encore, cet article se borne à constater l'existence d'effets résultant des variations de différents paramètres d'implantation, et ne suggère aucune exploitation de ces observations pour caractériser les paramètres d'implantation eux-mêmes.

En outre, ici encore une méthode relativement lourde, de type TEM, est mise en oeuvre pour observer le substrat implanté : dans le cas de cet article, ce sont des « défauts étendus » enterrés dans l'épaisseur d'un substrat qui sont observés.

On remarquera enfin que cet article s'attache à caractériser l'influence de la température d'implantation, et n'est aucunement centré sur l'influence de la dose d'implantation.

On signale également l'article de Da Silva et al. « The effects of implantation temperature on He bubble formation in silicon, Nuclear Instrument and methods in physics research, section B : Beam interactions with materials and atoms, North-Holland publishing company, Amsterdam, NL, vol. 175-177, avril 2001 (2001-04), pages 335-339.

Ici encore, l'article ne suggère aucunement d'exploiter les observations réalisées pour caractériser une dose d'implantation.

Et ici encore, des méthodes lourdes de type TEM ou RBS sont mises en oeuvre pour observer la structure du substrat implanté dans sa profondeur.

Par ailleurs, cet article est uniquement focalisé sur l'influence de la température d'implantation et ne considère pas les aspects liés à la dose.

On remarquera en outre que le recuit que subit le substrat dans le cas de cet article est de type RTA (acronyme anglo-saxon de Rapid Thermal Annealing pour recuit thermique rapide), alors que comme on va le voir dans le cas de la présente invention on cherche à éviter des températures de recuit trop importantes.

Il apparaît donc que les documents qui viennent d'être mentionnés et qui s'attachent à observer l'influence de différentes caractéristiques d'une étape d'implantation sur un substrat implanté ne répondent pas au besoin exprimé plus haut.

Le but de l'invention est de répondre à ce besoin.

Afin d'atteindre ce but, l'invention propose un procédé de caractérisation ex situ d'une d'implantation d'au moins une espèce dans un substrat selon la revendication 1.

Des aspects préférés, mais non limitatifs du procédé selon l'invention sont les suivants :
- lors de l'étape de traitement d'image on analyse la densité et la taille des bulles,
- lors de l'étape de traitement d'image, on calcule une surface bullée,
- la caractérisation de dose d'implantation comprend en outre la caractérisation de l'homogénéité spatiale de la dose implantée dans le substrat,
- on effectue différentes mesures de bullage en différents endroits du substrat, de manière à obtenir une répartition spatiale de dose à la surface du substrat,
- on effectue lesdites mesures sur plusieurs substrats auxquels on a fait subir l'étape de recuit dans les mêmes conditions avec des orientations individuelles différentes pour tenir compte des effets thermiques locaux lors de l'étape de recuit,
- l'espèce implantée est de l'hydrogène ou de l'hélium,
- le substrat est réalisé dans un matériau semiconducteur,
- ledit matériau est du silicium monocristallin.

D'autres aspects, buts et avantages de l'invention apparaîtront mieux à la lecture de la description suivante d'une forme de réalisation de l'invention, faite en référence aux dessins annexés sur lesquels :
- la figure 1 représente quatre vues successives de la surface d'un même substrat qui a été préalablement implanté, les quatre vues correspondant à quatre stades d'un recuit effectué selon l'invention, et formant ainsi une séquence temporelle illustrant l'évolution de l'aspect de la surface du substrat au fil du recuit,
- la figure 2 est un graphe montrant l'évolution de la densité de bulles générées par un recuit, en fonction de la durée de recuit,
- la figure 3 est un graphe illustrant l'effet d'une application de l'invention, qui consiste à établir des facteurs de compensation d'implanteurs, à partir de mesures de dose d'implantation réalisées selon l'invention,
- la figure 4 est un graphe illustrant un résultat de mesures de répartition spatiale de la densité de bulles sur la surface d'un wafer, dans différentes directions de mesure.

Le procédé de caractérisation selon l'invention est un procédé de caractérisation ex situ, c'est à dire qu'il permet de caractériser (par différents paramètres que l'on va détailler) une étape d'implantation qui a été préalablement réalisée dans un substrat.

Plus précisément, comme on va le voir le procédé selon l'invention permet de caractériser une dose d'implantation.

Et cette caractérisation est quantitative, et peut en outre être qualitative.

Par « caractérisation quantitative », on entend la détermination de la valeur de la dose implantée.

Par « caractérisation qualitative », on entend la caractérisation de l'homogénéité spatiale de la dose implantée dans le substrat : ce deuxième type de caractérisation s'attache donc à identifier les régions du substrat ayant reçu par unité de surface une dose supérieure, ou inférieure à la dose moyenne reçue par le substrat.

On désignera par « implanteur » le dispositif ayant permis d'implanter le substrat. Il peut être de tout type connu en soi.

Comme mentionné ci-dessus, dans une mise en oeuvre préférée de l'invention le substrat est en un matériau semiconducteur tel que le silicium monocristallin, et l'espèce d'implantation est de l'hydrogène.

Toutefois, le matériau du substrat et l'espèce implantée peuvent être différents ; on pourra ainsi par exemple caractériser un substrat de silicium implanté avec de l'hélium.

Partant donc d'un substrat qui a été préalablement implanté, le procédé de caractérisation selon l'invention comprend les étapes principales suivantes :
- une étape de recuit destinée à provoquer le bullage de l'espèce dans le substrat implanté,
- une étape d'acquisition d'une image de surface du substrat,
- une étape de traitement d'image.

L'étape de recuit est effectuée à une température et pendant une durée contrôlée, de manière à provoquer la formation de bulles d'hydrogène dans la région superficielle du substrat.

Un tel phénomène sera nommé ici « bullage », par correspondance avec l'appellation anglo-saxonne de « blistering ».

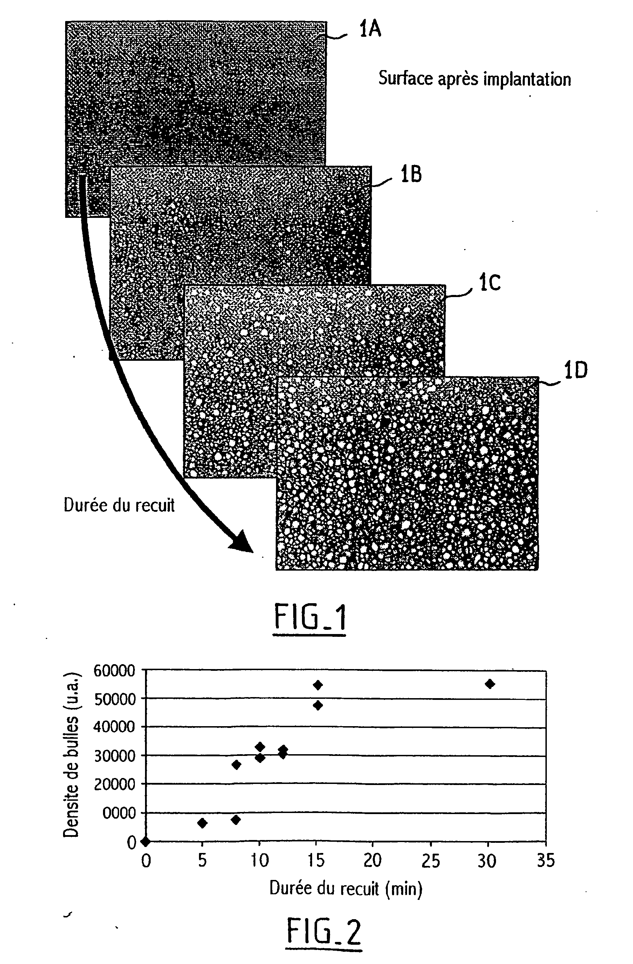

L'effet d'un tel recuit sur un substrat implanté est illustré sur la figure 1, dont les quatre vues successives représentent l'évolution de l'aspect de surface d'un substrat implanté (1A), à la surface duquel des bulles apparaissent au cours du recuit (1B et 1C, successivement selon la chronologie du recuit), jusqu'à un état où le phénomène de « bullage » est pratiquement achevé (1 D).

Le recuit dont les effets sont illustrés sur la figure 1 a été mené à une température de 440 °C.

Cet exemple de température n'est cependant pas limitatif. Il illustre simplement une valeur qui correspond à un bon compromis dans le cas de l'application préférée de l'invention.

En effet, la définition de cette température de recuit doit à la fois :
- être assez élevée pour favoriser le bullage qui nécessite un certain budget thermique (ledit budget dépendant essentiellement de la température et de la durée de recuit),
- et ne pas dépasser une valeur limite supérieure au delà de laquelle le budget thermique devient trop important, de sorte que certaines bulles formées lors du bullage viennent à éclater, ce qui ne permet plus une bonne caractérisation.

En contrôlant les paramètres (température, durée) du recuit, on provoque ainsi un bullage plus ou moins important de l'hydrogène implanté (tout en évitant que les bulles n'éclatent).

La figure 2 illustre l'évolution d'un paramètre représentatif de la densité surfacique de bulles à la surface du substrat (en ordonnées), en fonction de la durée d'un recuit (abscisses) dont la température est par ailleurs déterminée.

Il s'agit ici du même recuit que celui dont les effets sont illustrés sur la figure 1.

Ce paramètre de densité est issu d'un traitement de l'image de la surface du substrat après son recuit, que l'on a acquise par des moyens tels qu'un capteur CCD. Ce paramètre est typiquement lié au nombre de pixels correspondant à une surface bullée sur un champ de microscope.

Le paramètre de densité est lié en particulier aux facteurs suivants :
- seuil de discrimination utilisé dans le traitement de l'image microscopique,
- taille et définition de cette image,
- durée et température du recuit, et
- dose d'hydrogène réellement implantée dans le substrat.

Pour ceux de ces paramètres que l'on peut contrôler (c'est à dire tous, sauf la dose implantée), on définit des valeurs de fonctionnement ; la mesure résultante de densité sera exploitée pour calculer la dose implantée.

Pour calculer la dose qui a effectivement été implantée, on a préalablement réalisé une calibration pour établir une relation entre le paramètre de densité de bullage et la dose réelle (avec un implanteur et dans des conditions de référence).

Cette calibration a été effectuée en faisant subir à un substrat préalablement implanté avec une dose connue, un recuit selon l'invention, et en caractérisant ensuite sa surface bullée.

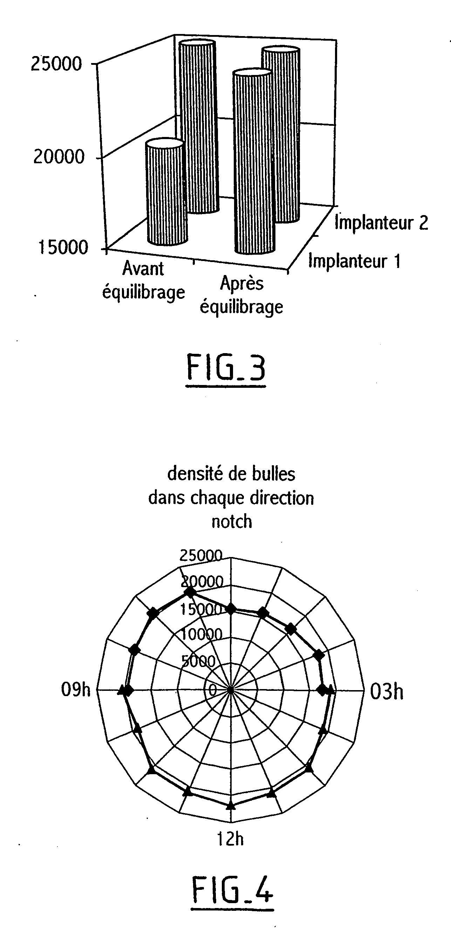

Et comme on va le voir en détail à propos de la figure 4, il est également possible d'analyser la répartition spatiale de la densité de bullage pour caractériser l'uniformité d'implantation.

Revenant à la définition des paramètres que l'on peut contrôler, un paramètre important est la durée de recuit.

La figure 2 fait apparaître que :
- pour des durées de recuit faibles (inférieures à 5 minutes sur la figure), l'effet de bullage n'est pas développé,
- il existe une plage de durées intermédiaire (entre 5 et 15 minutes sur la figure) pour lesquelles le bullage est développé, et croît avec la durée,
- au-delà d'une certaine durée de recuit (de l'ordre de 15 à 20 minutes sur la figure), on assiste à une « saturation » du bullage qui ne progresse plus.

Dans le cadre de l'invention, on choisira de préférence la durée de recuit (en fonction de sa température bien sûr) de sorte que le bullage soit largement développé, et ait atteint un stade précédant immédiatement la saturation (donc de l'ordre de 15 minutes dans le cas de l'exemple de la figure 2).

En effet, d'une part il faut éviter un recuit trop court :
- il est important d'avoir un bullage développé, permettant des mesures exploitables - ceci nécessite une durée minimale comme le montre la figure 2,
- par ailleurs, une durée de recuit trop courte expose le substrat aux effets locaux de température dans les fours de recuit (points froids/chauds ...) - on peut gommer ces effets en prolongeant le recuit.

Mais d'autre part, il est tout de même souhaitable de ne pas prolonger le recuit au-delà de la durée de saturation :
- ceci est lié au fait qu'en prolongeant le recuit de manière excessive, on risque de favoriser l'explosion de cloques formées par certaines bulles à la surface du substrat. Et une surface de substrat implanté qui comporterait certaines bulles ayant éclaté serait difficile à caractériser, du fait des problèmes de discrimination visuelle entre bulles éclatées/bulles non éclatées/fond du substrat.

Une durée de recuit bien adaptée est donc une durée suffisante pour garantir un bon développement du bullage, mais n'ayant pas dépassé la durée de saturation.

Dans une application particulière de l'invention, on exploite les mesures de dose d'hydrogène réalisées par traitement d'image de substrat ayant subi un recuit, pour déterminer des facteurs de compensation devant être appliqués à divers implanteurs.

En effet, dans le cas d'une mise en oeuvre industrielle de l'implantation, on peut être amené à utiliser plusieurs implanteurs différents (bien qu'éventuellement de même conception), pour implanter en parallèle des substrats.

Et il est souhaitable de pouvoir commander l'opération de ces implanteurs par une consigne unique, qui est transmise à chacun de ces implanteurs.

Or, deux implanteurs différents et recevant la même consigne (c'est à dire étant commandés pour implanter les mêmes doses), même s'ils ont été conçus de la même manière, sont susceptibles d'effectuer en réalité des implantations avec des doses différentes.

On constate ainsi typiquement des écarts pouvant être de l'ordre de 5%.

Il est donc nécessaire de choisir un implanteur de référence et d'associer à chaque autre implanteur un facteur de compensation, qui permet d'adapter la consigne individuelle de l'implanteur en question par multiplication de la consigne commune, afin que tous les implanteurs implantent effectivement les mêmes doses.

Le facteur de compensation est ainsi voisin de l'unité - il peut typiquement descendre jusqu'à une valeur d'environ 0,9.

Cette opération de définition d'un facteur de compensation peut être appelée « équilibrage ».

La figure 3 illustre les mesures des doses réellement implantées par deux implanteurs différents, mesures effectuées selon l'invention en, mettant en oeuvre les mêmes recuits.

Plus précisément, pour chaque implanteur on a mesuré la dose avant équilibrage (deux mesures de gauche sur la figure 4), et après équilibrage (deux mesures de droite sur cette figure).

Les ordonnées sont un paramètre de densité qui représente la dose implantée.

On constate qu'avant équilibrage, une différence significative du paramètre de densité existe entre les implantations réalisées par les deux implanteurs respectifs : ce paramètre a une valeur de 20000 pour l'implanteur 1, alors qu'il a une valeur de 24000 pour l'implanteur 2.

Cette différence importante du paramètre de densité correspond à une différence de 1% dans les doses réellement implantées par les deux implanteurs.

Ainsi, le paramètre de densité est très sensible aux variations de dose, et il permet de détecter des variations faibles.

Dans l'exemple de la figure 3, un écart de 1% est aisément détecté.

Et il est ainsi possible de définir pour l'implanteur 1 un facteur de compensation, l'implanteur 2 servant d'implanteur de référence.

La partie droite de la figure 3 montre qu'après prise en compte de ce facteur de compensation (c'est à dire que la consigne de dose de l'implanteur 1 a été multipliée par ledit facteur de compensation), les deux implanteurs implantent bien les mêmes doses.

On remarquera que la méthode selon l'invention permet ainsi de déterminer une dose d'implantation avec une précision de l'ordre de 1% ou mieux, ce qui constitue une amélioration sensible par rapport aux méthodes connues.

Le procédé selon l'invention offre donc l'avantage de pouvoir déterminer une dose d'implantation avec une grande précision.

Et un autre avantage de ce procédé est qu'il est simple à mettre en oeuvre.

En particulier, l'observation du substrat implanté est une observation d'image de surface, réalisée par des moyens standard du type capteur CCD.

Ceci constitue une différence supplémentaire avec les techniques de l'art antérieur, qui mettent en oeuvre des moyens généralement lourds et complexes pour réaliser des observations d'un substrat implanté (ces observations étant généralement réalisées dans l'épaisseur du substrat).

La figue 4 illustre un autre mode d'exploitation de la mesure du paramètre de densité, qui permet de caractériser l'uniformité de dose implantée sur la surface du substrat.

Ce mode d'exploitation peut être combiné avec les dispositions décrites ci-dessus.

La figure 4 représente une mesure de la dose réellement implantée - et mesurée selon l'invention comme décrit ci-dessus - sur le pourtour d'un substrat. Elle fait apparaître une sous-implantation dans le secteur midi-02 heures.

Cette mesure est fonction du budget thermique localement absorbé par le substrat lors du recuit. Elle dépend donc de l'uniformité de température dans le four de recuit.

Pour compenser des éventuelles inhomogénéités de température dans le four de recuit, il est possible de faire tourner le substrat lors du recuit.

Il est également possible d'effectuer le recuit sur plusieurs substrats identiques ayant été implantés dans les mêmes conditions et par le même implanteur (ou par des implanteurs convenablement compensés les uns par rapport aux autres - voir ci-dessus).

Dans ce dernier cas où l'on effectue le recuit sur plusieurs substrats identiques, chaque substrat est orienté différemment dans le four de recuit de manière à s'affranchir des effets thermiques locaux.

Par exemple, pour s'affranchir de l'effet orthoradial mis en évidence par la figure 4, on disposera les substrats avec des orientations angulaires régulièrement espacées entre 0° et 360°.

Et on moyennera alors les mesures effectuées sur les substrats identiques qui ont été orientés différemment dans le four de recuit.

Et de manière générale, en présence d'une mesure individuelle de répartition spatiale de dose mettant en évidence une anomalie locale, on établira si cette anomalie est due au recuit, par une répartition adaptée des substrats identiques dans un même four de manière à s'affranchir des effets thermiques locaux puis un moyennage des mesures sur les substrats.

Une fois de telles mesures prises pour neutraliser les effets locaux des fours de recuit, il est possible d'obtenir une vue synoptique des doses implantées à la surface d'un substrat, et de caractériser l'uniformité d'implantation.

L'invention offre ainsi une méthode simple et non onéreuse de caractérisation d'implantation (le temps de recuit, d'acquisition d'image et d'analyse par traitement d'image est inférieur à deux heures).

Elle ne nécessite pas d'équipement spécialisé et est applicable sans spécification sur tous types de substrats implantés.

## Revendications

1. Procédé de caractérisation ex situ de dose d'implantation d'au moins une espèce dans un substrat, comprenant :
une étape de recuit destinée à provoquer le bullage de l'espèce dans le substrat implanté,
une étape d'acquisition d'une image de surface du substrat,
une étape de traitement d'image de laquelle on déduit des caractéristiques de dose d'implantation dont une mesure de dose implantée,
ledit procédé étant **caractérisé en ce que**, préalablement auxdites étapes, on réalise une calibration de la densité de bulles en fonction de la dose d'implantation et **en ce que** l'on déduit la mesure de dose implantée d'un paramètre de densité de bullage, et l'on exploite la mesure de dose implantée pour établir un facteur de compensation d'un implanteur.

2. Procédé selon la revendication précédente, **caractérisé en ce que** lors de l'étape de traitement d'image on analyse la densité et la taille des bulles.

3. Procédé selon l'une des revendications précédentes, **caractérisé en ce que** lors de l'étape de traitement d'image, on calcule une surface bullée.

4. Procédé selon l'une des revendications précédentes, **caractérisé en ce que** l'on déduit en outre de l'étape de traitement d'image la caractérisation de l'homogénéité spatiale de la dose implantée dans le substrat.

5. Procédé selon la revendication précédente, **caractérisé en ce que** l'on effectue différentes mesures de bullage en différents endroits du substrat, de manière à obtenir une répartition spatiale de dose à la surface du substrat.

6. Procédé selon la revendication précédente, **caractérisé en ce que** l'on effectue lesdites mesures sur plusieurs substrats auxquels on a fait subir l'étape de recuit dans les mêmes conditions avec des orientations individuelles différentes pour tenir compte des effets thermiques locaux lors de l'étape de recuit.

7. Procédé selon l'une des revendications précédentes, **caractérisé en ce que** l'espèce implantée est de l'hydrogène ou de l'hélium.

8. Procédé selon l'une des revendications précédentes, **caractérisé en ce que** le substrat est réalisé dans un matériau semiconducteur.

9. Procédé selon la revendication précédente, **caractérisé en ce que** ledit matériau est du silicium monocristallin.

## Claims

1. A method of ex situ characterization of the implanted dose of at least one species in a substrate, the method comprising:
an annealing step for causing the species to blister in the implanted substrate;
• a step of acquiring an image of the surface of the substrate; and
• a step of processing the image from which implantation dose characteristics, including an implanted dose measurement, are deduced;
said method being **characterized in that**, prior to said steps, blister density is calibrated as a function of implantation dose, and **in that** the measurement of implanted dose is deduced from a blister density parameter, and an implanted dose measurement is used to establish a compensation factor for an implanter.

2. A method according to the preceding claim, **characterized in that** during the image processing step, the density and the size of the blisters are analyzed.

3. A method according to any preceding claim, **characterized in that** during the image processing step, the blister area is calculated.

4. A method according to any preceding claim, **characterized in that** the spatial uniformity characterization of the implanted dose over the substrate is further deduced from the image processing step.

5. A method according to the preceding claim, **characterized in that** different blister measurements are performed on different locations of the substrate so as to obtain a spatial distribution of dose over the surface of the substrate.

6. A method according to the preceding claim, **characterized in that** said measurements are performed on a plurality of substrates which have been subjected to the annealing step under the same conditions with different individual orientations in order to take account of local temperature effects during the annealing step.

7. A method according to any preceding claim, **characterized in that** the implanted species is hydrogen or helium.

8. A method according to any preceding claim, **characterized in that** the substrate is made of a semiconductor material.

9. A method according to the preceding claim, **characterized in that** said material is single-crystal silicon.

## Patentansprüche

1. Verfahren zur ex-situ Charakterisierung einer Implantierungsdosis wenigstens einer Spezies in einem Substrat, welches umfasst:
einen Glühschritt, der dazu bestimmt ist, die Blasenbildung in dem implantierten Substrat zu veranlassen,
einen Schritt zur Erfassung eines Oberflächenbildes des Substrats,
einen Schritt zur Bildbearbeitung, aus dem Implantierungsdosismerkmale, darunter eine Messung implantierter Dosis, hergeleitet werden,
wobei das Verfahren **dadurch gekennzeichnet ist, dass** vor den Schritten, eine Kalibrierung der Blasendichte in Abhängigkeit der Implantierungsdosis durchgeführt wird und dass die Messung implantierter Dosis aus einem Blasendichteparameter hergeleitet wird und dass die Messung implantierter Dosis ausgewertet wird, um einen Kompensationsfaktor eines Implantierers zu ermitteln.

2. Verfahren gemäß dem vorhergehenden Anspruch, **dadurch gekennzeichnet, dass** beim Bildverarbeitungsschritt die Dichte und die Größe der Blasen analysiert werden.

3. Verfahren gemäß einem der vorhergehenden Ansprüche, **dadurch gekennzeichnet, dass** beim Bildverarbeitungsschritt eine Blasenoberfläche berechnet wird.

4. Verfahren gemäß einem der vorhergehenden Ansprüche, **dadurch gekennzeichnet, dass** außerdem aus dem Bildverarbeitungsschritt die Charakterisierung der räumlichen Homogenität der im Substrat implantierten Dosis hergeleitet wird.

5. Verfahren gemäß dem vorhergehenden Anspruch, **dadurch gekennzeichnet, dass** verschiedene Blasenmessungen an verschiedenen Orten des Substrats durchgeführt werden, um eine räumliche Dosisverteilung an der Oberfläche des Substrats zu erhalten.

6. Verfahren gemäß dem vorhergehenden Anspruch, **dadurch gekennzeichnet, dass** die Messungen auf mehreren Substraten durchgeführt werden, die man dem Glühschritt unter denselben Bedingungen mit einzelnen verschiedenen Ausrichtungen unterzogen hat, um die lokalen thermischen Effekte beim Glühschritt zu berücksichtigen.

7. Verfahren gemäß einem der vorhergehenden Ansprüche, **dadurch gekennzeichnet, dass** die implantierte Spezies Wasserstoff oder Helium ist.

8. Verfahren gemäß einem der vorhergehenden Ansprüche, **dadurch gekennzeichnet, dass** das Substrat aus einem Halbleitermaterial hergestellt ist.

9. Verfahren gemäß dem vorhergehenden Anspruch, **dadurch gekennzeichnet, dass** das Material monokristallines Silizium ist.
